# EUROPEAN PATENT APPLICATION

(11) **EP 4 765 561 A1**
(43) Date of publication of application: **24.06.2026**
(21) Application number: 24894375.5
(22) Date of filing: 14.10.2024
(51) Int. Cl.: H02J 7/00, H01M 10/48, G01R 31/396, H04L 12/40, H01M 10/42

(54) **BATTERY MANAGEMENT DEVICE AND OPERATION METHOD THEREOF**

(30) Priority: 20.11.2023 KR 20230160245
(71) Applicant: LG Energy Solution, Ltd., Seoul 07335 (KR)
(72) Inventor: YOON, Sun Woo, Daejeon 34122 (KR); KIM, Young Beom, Daejeon 34122 (KR)
(74) Representative: Plasseraud IP
(86) International application number: PCT/KR2024/015495
(87) International publication number: WO 2025/110479

(57) **Abstract**

A battery management apparatus according to an embodiment disclosed herein includes a first communication unit configured to broadcast a wide-area signal for communication with a plurality of slave battery management systems (BMSs) to the plurality of slave BMSs, a second communication unit configured to transmit a direct signal for direction communication with a specific slave BMS among the plurality of slave BMSs to the specific slave BMS, and a controller configured to control operations of the first communication unit and the second communication unit.

## Description

### TECHNICAL FIELD

### CROSS-REFERENCE TO RELATED APPLICATION

This application claims priority to and the benefit of Korean Patent Application No. 10-2023-0160245 filed in the Korean Intellectual Property Office on November 20, 2023, the entire content of which is incorporated herein by reference.

### TECHNICAL FIELD

Embodiments disclosed herein relate to a battery management apparatus and an operating method thereof.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

As industrial fields using batteries expand, battery management systems (BMSs) diagnosing safety of batteries are also developing. The BMS may diagnose performance of a battery by using various diagnosis algorithms, and perform appropriate control according to a state of the battery.

BMSs may include a master BMS and a slave BMS. The slave BMS may manage a battery module, included in a battery pack, based on state information regarding the battery module. The master BMS may receive the state information regarding the battery module from the slave BMS, measure voltage, current, and resistance values in the unit of a battery pack, and monitor states of the battery module included in the battery pack and battery cells.

### DISCLOSURE

### TECHNICAL PROBLEM

A BMS may include a plurality of sensors for measuring a state of a battery, a state value of the battery, measured by the sensors, may be transmitted to a master BMS through a slave BMS. For transmission, the sensor, the salve BMS, and/or the master BMS may be generally connected wiredly. However, as the number of battery cells is large or the number of sensors is large, the number of wires required also increases.

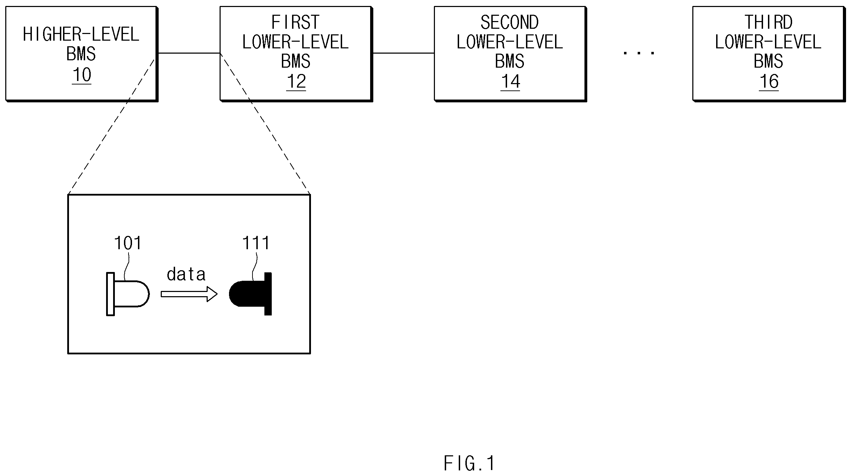

FIG. 1 shows a communication scheme inside a general wireless battery management system (BMS). Referring to FIG. 1, to solve the foregoing problem, data is exchanged through optical communication without a separate wire between a higher-level BMS 10 and lower-level BMSs 12, 14, and 16, thereby managing the battery with a simplified structure. Herein, the higher-level BMS 10 may be a master BMS, and each of the lower-level BMSs 12, 14, and 16 may be a slave BMS. For example, the higher-level BMS 10 may transmit a signal through a light-emitting diode 101 that transmits an optical signal, and the first lower-level BMS 12 may receive the signal through a receiver 111. Communication between the first lower-level BMS 12 and the second lower-level BMS 14 and data communication between the second lower-level BMS 14 and the third lower-level BMS 16 may be the same as a communication scheme between the higher-level BMS 10 and the first lower-level BMS 12.

However, optical communication between the higher-level BMS 10 and the lower-level BMSs 12, 14, and 16 may be of a daisy chain type, and the higher-level BMS 10 may issue a command to the first lower-level BMS 12 and the other lower-level BMSs 14 and 16 may sequentially receive a command through the first lower-level BMS 12. In this case, there is a difference in time when each of the lower-level BMSs 12, 14, and 16 receives a command.

Technical problems of the embodiments disclosed herein are not limited to the above-described technical problems, and other unmentioned technical problems would be clearly understood by one of ordinary skill in the art from the following description.

### TECHNICAL SOLUTION

A battery management apparatus according to an embodiment disclosed herein includes a first communication unit configured to broadcast a wide-area signal for communication with a plurality of slave battery management systems (BMSs) to the plurality of slave BMSs, a second communication unit configured to transmit a direct signal for direction communication with a specific slave BMS among the plurality of slave BMSs to the specific slave BMS, and a controller configured to control operations of the first communication unit and the second communication unit.

In an embodiment, the first communication unit may further include a condensing mirror configured to concentrate light on a specific point by reflecting the wide-area signal.

In an embodiment, the first communication unit may further include a first light-emitting diode configured to transmit the wide-area signal, and the second communication unit may further include a second light-emitting diode configured to transmit the direct signal.

In an embodiment, the first communication unit may further include a first switch configured to supply current to the first light-emitting diode, and the second communication unit may further include a second switch configured to supply current to the second light-emitting diode, and the controller may be further configured to control an operation of at least one of the first switch and the second switch.

In an embodiment, the second communication unit may further include a receiver configured to receive diagnosis data regarding a battery generated by at least one of the plurality of slave BMSs based on the wide-area signal or the direct signal.

In an embodiment, the diagnosis data may include at least one of voltage, current, and temperature of the battery.

In an embodiment, the wide-area signal may include a block signal for blocking communication in a daisy chain manner among the plurality of slave BMSs.

An operating method of a battery management apparatus according to an embodiment disclosed herein includes broadcasting a wide-area signal for communication with a plurality of slave battery management systems (BMSs) to the plurality of slave BMSs and reflecting the wide-area signal to simultaneously transmit the wide-area signal to a receiver of each of the plurality of slave BMSs.

In an embodiment, the wide-area signal may include a block signal for blocking communication in a daisy chain manner among the plurality of slave BMSs.

In an embodiment, the operating method may further include receiving diagnosis data regarding a battery generated by at least one of the plurality of slave BMSs based on the wide-area signal.

In an embodiment, the diagnosis data may include at least one of voltage, current, and temperature of the battery.

### ADVANTAGEOUS EFFECTS

A battery management apparatus and an operating method thereof according to various embodiments disclosed herein may simultaneously transmit a signal to a plurality of slave BMSs by using a wide-area light-emitting diode. Thus, a time delay due to signal transmission of the daisy chain communication type may be prevented.

The technical effects of the battery management apparatus and the operating method thereof according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 shows a communication scheme inside a general wireless battery management system (BMS).
FIG. 2 is a block diagram of a battery management apparatus, according to an embodiment disclosed herein.
FIG. 3A illustrates a battery rack including a battery management apparatus according to an embodiment disclosed herein.
FIG. 3B shows a configuration of a first communication unit according to an embodiment disclosed herein.
FIG. 4 shows a process, performed by a controller, of controlling an operation of a switch based on a wide-area signal or a direct signal, according to an embodiment disclosed herein.
FIG. 5 is a flowchart showing an operating method of a battery management apparatus according to an embodiment disclosed herein.
FIG. 6 is a block diagram showing a hardware configuration of a computing system for implementing an operating method of a battery management apparatus, according to an embodiment disclosed herein.

With regard to the description of the drawings, identical reference numerals may be used to refer to identical or related elements.

### MODE FOR INVENTION

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or distributed online through an application store or directly between two user devices (e.g. downloaded or uploaded). In the case of online distribution, at least a part of a computer program product may be at least temporarily stored in a machine-readable storage medium such as a memory of a server of a manufacturer, a server of an application store, or a relay server, or may be generated temporarily. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

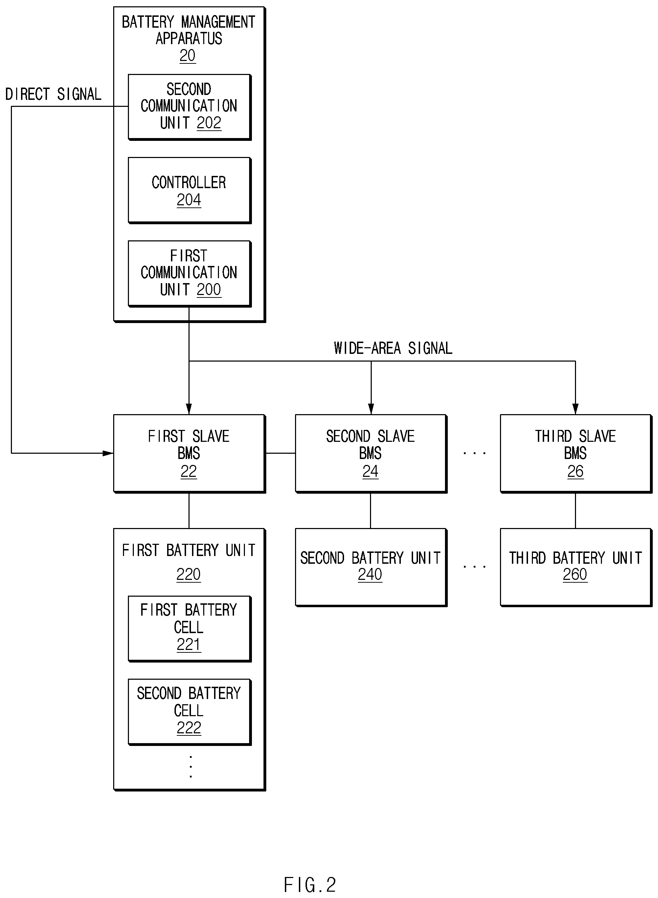

FIG. 2 illustrates a battery rack including a battery management apparatus according to an embodiment disclosed herein.

Referring to FIG. 2, a battery management apparatus 20 may perform data exchange with a plurality of slave BMSs 22, 24, and 26 through wide-area communication or direct communication. The battery management apparatus 20 may simultaneously transmit a diagnosis command for diagnosing the battery to the plurality of slave BMSs 22, 24, and 26 through wide-area communication, thereby solving a time delay problem occurring due to a daisy chain communication scheme.

According to an embodiment, the battery management apparatus 20 may be a master BMS. Herein, the master BMS may obtain state information generated by each of the slave BMSs to monitor a state of each of battery cells. Herein, the state information may include at least one of voltage, current, resistance, state of charge (SOC), state of health (SOH), and temperature of a battery pack, a battery module, or each battery cell.

In an embodiment, the battery management apparatus 20 may be included in the master BMS, and operations performed in the battery management apparatus 20 may be performed in the master BMS. The operations performed in the battery management apparatus 20 may also be performed in various devices such as not only the master BMS, but also a server, a cloud, a charger, a charger/discharger, etc.

Each of the plurality of slave BMSs 22, 24, and 26 may measure a state of each of corresponding battery units 220, 240, and 260. Herein, each of the battery units 220, 240, and 260 may indicate a group including one or more battery cells. For example, each of the battery units 220, 240, and 260 may include one or more battery modules or one or more battery cells. While three slave BMSs are shown in FIG. 2, the number of slave BMSs may not be limited thereto.

Each of the plurality of slave BMSs 22, 24, and 26 may generate diagnosis data regarding each of the battery units 220, 240, and 260. Herein, the diagnosis data may include at least one of voltage, current, and temperature of each battery cell included in each of the battery units 220, 240, and 260. For example, the first slave BMS 22 may generate diagnosis data to diagnose states of battery cells 221 and 222 included in the first battery unit 220. According to an embodiment, the battery cells 221 and 222 may include, but not limited to, a lithium-ion (Li-ion) battery, an Li-ion polymer battery, a nickelcadmium (Ni-Cd) battery, a nickel metal hydride (Ni-MH) battery, a lithium iron phosphate (LFP) battery, a nickel cobalt manganese oxide (NCM) battery, etc. While a description of the battery cells 221 and 222 included in the first battery unit 220 is disclosed in FIG. 2, this is merely for convenience of the description and the second battery unit 240 and the third battery unit 260 may also include a plurality of battery cells.

In an embodiment, the plurality of slave BMSs 22, 24, and 26 may be connected in a daisy chain manner. Herein, the daisy chain manner may include a manner in which a plurality of devices are continuously connected in a bus connection manner. For example, the first slave BMS 22 may be connected to the second slave BMS 24 that may be connected to the third slave BMS 26. Third diagnosis data generated in the third slave BMS 26 may be transmitted to the first slave BMS 22 through the second slave BMS 24, and the first slave BMS 22 may transmit the third diagnosis data to the battery management apparatus 20.

In an embodiment, connection in the daisy chain manner among the plurality of slave BMSs 22, 24, and 26 may be wired or wireless connection, and for wireless communication, data may be exchanged among the plurality of slave BMSs 22, 24, and 26 through optical communication.

Hereinbelow, optical communication and direct communication between the battery management apparatus 20 and the slave BMSs 22, 24, and 26 will be described.

The battery management apparatus 20 may include a first communication unit 200, a second communication unit 202, and a controller 204.

The first communication unit 200 may broadcast a wide-area signal to the plurality of slave BMSs 22, 24, and 26. The first communication unit 200 may broadcast a wide-area signal to the plurality of slave BMSs 22, 24, and 26 through wide-area communication.

The wide-area communication may refer to communication in a one-to-multi communication manner between the first communication unit 200 and the plurality of slave BMSs 22, 24, and 26. The wide-area signal may be a signal instructing each of the plurality of slave BMSs 22, 24, and 26 to measure a state of each of the corresponding battery units 220, 240, and 260. As the first communication unit 200 may broadcast the wide-area signal to the plurality of slave BMSs 22, 24, and 26, the plurality of slave BMSs 22, 24, and 26 may simultaneously receive the wide-area signal. Thus, a time delay caused by signal transmission in the daisy chain communication manner among slave BMSs may be prevented.

In an embodiment, the signal may include a block signal. Herein, the block signal may be a signal blocking communication in the daisy chain manner among the slave BMSs 22, 24, and 26. As the wide-area signal includes the block signal, wide-area signal transmission among the plurality of slave BMSs 22, 24, and 26 is blocked, thereby blocking redundant transmission of the wide-area signal. For example, when the first slave BMS 22 receives the wide-area signal including the block signal, the first slave BMS 22 may not transmit the wide-area signal to the second slave BMS 24, thereby preventing the second slave BMS 24 from redundantly receiving the wide-area signal.

The second communication unit 202 may transmit the direct signal to a specific slave BMS among the plurality of slave BMSs 22, 24, and 26. The second communication unit 202 may transmit the direct signal to a specific slave BMS among the plurality of slave BMSs 22, 24, and 26, through direct communication. Herein, the specific slave BMS may indicate a slave BMS connected to the battery management apparatus 20 in the daisy chain manner, and hereinbelow, the specific slave BMS is assumed to be the first slave BMS 22.

The direct communication may be one-to-one communication between the second communication 202 and the first slave BMS 22 in the daisy chain manner, and may be the same as a communication manner between the higher-level BMS 10 (see FIG. 1) and the first lower-level BMS 12 (see FIG. 1) of FIG. 1.

In an embodiment, the second communication unit 202 may further include a receiver (not shown). The receiver may receive diagnosis data regarding the battery, generated by at least one of the plurality of slave BMSs 22, 24, and 26, based on the wide-area signal or the direct signal. A manner in which the receiver receives the diagnosis data may be the daisy chain communication manner and may be the same as a communication manner between the higher-level BMS 10 (see FIG. 1) and the first lower-level BMS 12 (see FIG. 1) of FIG. 1. For example, when each of the plurality of slave BMSs 22, 24, and 26 generates the diagnosis data based on the wide-area signal, the first slave BMS 22 may receive the diagnosis data generated by the other slave BMSs 24 and 26 through daisy chain communication and transmit the same to the receiver.

Herein, a reason why the receiver receives the diagnosis data generated based on the wide-area signal through daisy chain communication is to minimize power consumption. Based on the following description, to broadcast the wide-area signal, a broadband light-emitting diode may be required. The broadband light-emitting diode may consume greater power than a light-emitting diode that performs the daisy chain communication manner because of having a wider transmission range and a stronger transmission signal. Thus, the battery management apparatus 20 may receive diagnosis data, generated after simultaneous transmission of the wide-area signal to the plurality of slave BMSs 22, 24, and 26, through daisy chain communication, thereby minimizing power consumption.

The controller 204 may control operations of the first communication unit 200 and the second communication unit 202. In an embodiment, the controller 204 may generate a wide-area signal and/or a direct signal and control the operations of the first communication unit 200 and/or the second communication unit 202 based on a type of the generated signal. For example, the controller 204 may generate the wide-area signal and control the first communication unit 200 to perform an operation for transmitting the generated wide-area signal. The controller 204 may generate the direct signal and control the second communication unit 202 to perform an operation for transmitting the generated direct signal.

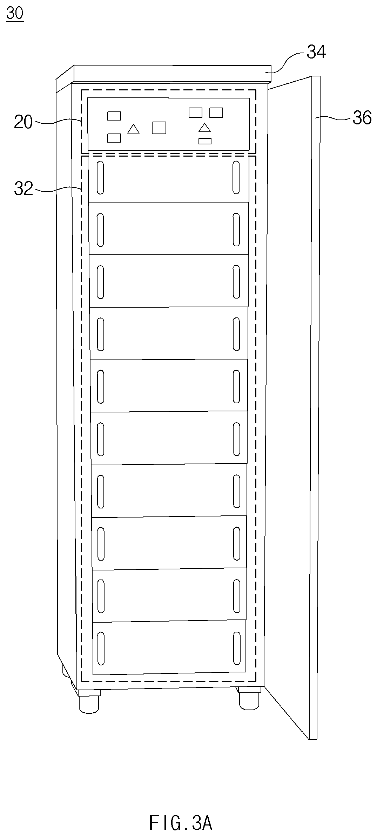

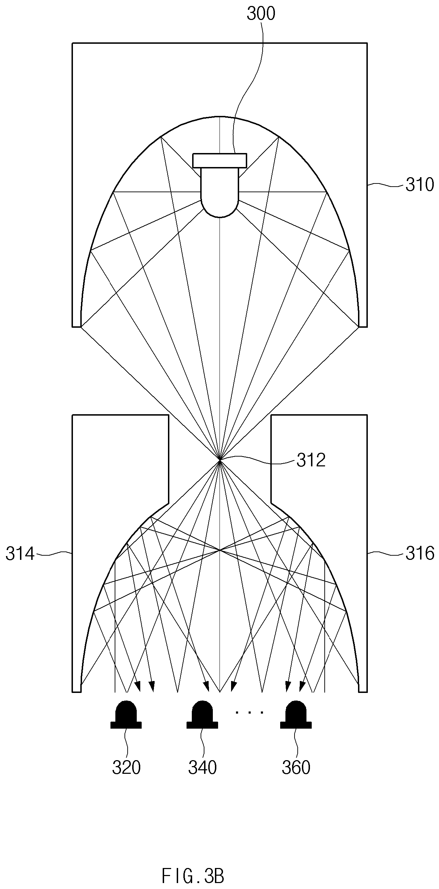

Hereinbelow, matters related to broadcasting of the wide-area signal will be described with reference to FIGS. 3A and 3B.

FIG. 3A illustrates a battery rack including a battery management apparatus according to an embodiment disclosed herein.

Referring to FIG. 3A, a structure of a battery rack 30 for broadcasting a wide-area signal by the battery management apparatus 20 is shown.

The battery rack 30 may include the battery management apparatus 20, trays 32 including a plurality of battery cells, and a carrier 34 for protecting the above-described components. Herein, each of the trays 32 may include the slave BMSs 22, 24, and 26 and the battery units 220, 240, and 260. In the battery rack 30, the battery management apparatus 20 and each of the trays 32 may be arranged vertically. The carrier 34 may have a hexahedron structure, and a part of the carrier 34 may be a door 36 for inserting or withdrawing the battery management apparatus 20 and the trays 32. Herein, the battery management apparatus 20 may be a master BMS, and the battery management apparatus 20 may transmit the wide-area signal to the slave BMS included in each of the trays 32.

The first communication unit 200 of the battery management apparatus 20 may transmit the wide-area signal to the slave BMS included in each of the trays 32. The wide-area signal may be transmitted to the slave BMS of each of the trays 32 through the first light-emitting diode 300 of the first communication unit 200. Herein, the wide-area signal may be an infrared (IR) ray transmitted from the first light-emitting diode 300. In FIG. 3A, the wide-area signal is assumed to be an IR ray.

In an embodiment, the structure of the battery rack 30 may include a component facilitating IR reflection. For example, the door 36 of the battery rack 30 may include a component facilitating reflection. The inner side of the door 36 may be painted with a paint facilitating IR reflection, and an IR reflectance may be improved by the paint. The paint applied to the inner side of the door 36 may be a paint that reflects about 50 % to about 100 % of the IR ray. By improving a reflectance with respect to the wide-area signal through the paint, transmission of the wide-area signal may be further facilitated. While the inner side of the door 36 is painted with the paint in FIG. 3A for convenience of a description, the present disclosure is not limited thereto and a paint facilitating IR reflection may be applied to the entire inner side of the carrier 34 or a part thereof.

FIG. 3B shows a configuration of a first communication unit according to an embodiment disclosed herein.

Referring to FIG. 3B, the first communication unit 200 and/or each of the plurality of slave BMSs 22, 24, and 26 may include a component for broadcasting a wide-area signal.

The first communication unit 200 may include the first light-emitting diode 300. The first light-emitting diode 300 may be a broadband light-emitting diode. Herein, the broadband light-emitting diode may include a lens for enlarging a transmission range to transmit the wide-area signal at 360 degrees. For the first light-emitting diode 300, a broadband light-emitting diode may be selected, thereby improving a transmission range and a transmission strength of the wide-area signal.

In an embodiment, the first communication unit 200 may further include a transmitting condensing mirror 310. A mirror plane of the transmitting condensing mirror 310 may have a semi-elliptical arch structure. The first light-emitting diode 300 may be located on a first focus of the transmitting condensing mirror 310. As the first light-emitting diode 300 is located on the first focus of the semi-elliptical arch structure, an IR ray transmitted by the first light-emitting diode 300 may be reflected by the transmitting condensing mirror 310 and thus may be concentrated on a second focus 312. Thus, by reflecting the IR ray with the transmitting condensing mirror 310, a transmission direction of the IR ray may be changed toward receivers 320, 340, and 360. Herein, the first receiver 320 may be included in the first slave BMS 22, and the second receiver 340 and the third receiver 360 may be respectively included in the second slave BMS 24 and the third slave BMS 26.

Each of the plurality of slave BMSs 22, 24, and 26 may include a receiver for receiving a wide-area signal. In an embodiment, the receivers 320, 340, and 360 may easily receive the wide-area signal by using receiving condensing mirrors 314 and 316 corresponding to the transmitting condensing mirror 310. In order for the IR ray concentrated on the second focus 312 to reach a reception range of the receivers 320, 340, and 360, the receiving condensing mirrors 314 and 316 may be arranged at a position based on the second focus 312 and positions and the reception range of the receivers 320, 340, and 360. The above-described transmitting condensing mirror 310 and receiving condensing mirrors 314 and 316 may be arranged not to interfere with a path of wide-area communication and/or direct communication.

While the wide-area signal is transmitted to the receivers 320, 340, and 360 through one condensing set including the first receiving condensing mirror 314 and the second receiving condensing mirror 316 for convenience of a description in FIG. 3B, the present disclosure is not limited thereto, and a plurality of condensing sets may be included and each of them may be arranged to correspond to a reception range of each of the receivers 320, 340, and 360.

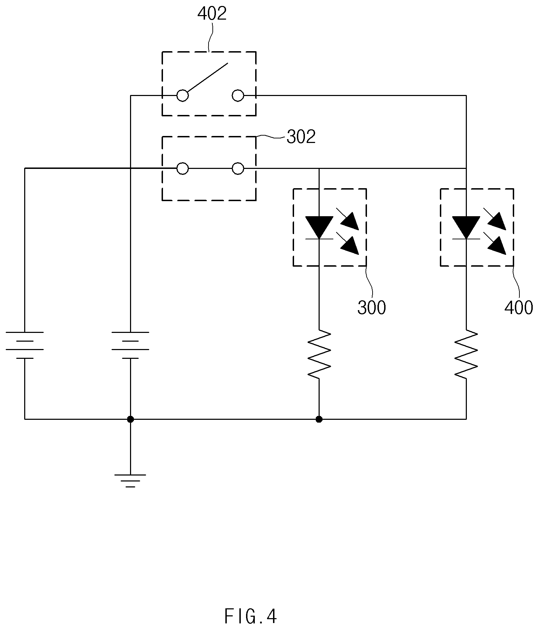

FIG. 4 shows a process, performed by a controller, of controlling an operation of a switch based on a wide-area signal or a direct signal, according to an embodiment disclosed herein.

Referring to FIG. 4, the first communication unit 200 may include a first light-emitting diode 300 and a first switch 302. The second communication unit 202 may include a second light-emitting diode 400 and a second switch 402. Herein, when the first switch 302 is turned on, the wide-area signal may be transmitted, and when the second switch 402 is turned on, the direct signal may be transmitted through daisy chain communication.

The controller 204 may control operations of the first switch 302 and the second switch 402. For example, when the wide-area signal is generated by a higher-level processor, the controller 204 may control the first switch 302 to be turned on and the second switch 402 to be turned off.

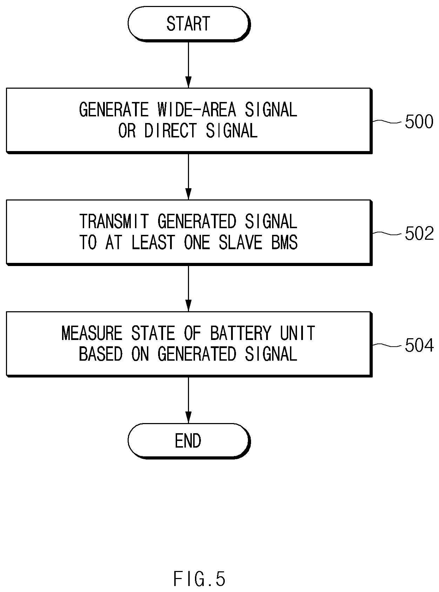

FIG. 5 is a flowchart showing an operating method of a battery management apparatus according to an embodiment disclosed herein.

Referring to FIG. 5, in operation 500, the battery management apparatus 20 may generate a wide-area signal or a direct signal.

In operation 502, the battery management apparatus 20 may transmit the generated signal to at least one slave BMS. The battery management apparatus 20 may broadcast the wide-area signal to the plurality of slave BMSs 22, 24, and 26. The battery management apparatus 20 may transmit the direct signal to the first slave BMS 22.

In operation 504, at least one slave BMS may measure a state of a battery unit based on the generated signal. Each of the plurality of slave BMSs 22, 24, and 26 may simultaneously measure a state of a battery unit corresponding to each slave BMS based on the wide-area signal. The first slave BMS 22 may measure the state of the first battery unit 220 based on the direct signal. In an embodiment, the first slave BMS 22 may transmit the direct signal to the second slave BMS 24 in the daisy chain communication manner, and the second slave BMS 24 may transmit the direct signal to the third slave BMS 26 in the daisy chain communication manner.

In an embodiment, the controller 204 of the battery management apparatus 20 may control operations of the first communication unit 200 and the second communication unit 202 based on the wide-area signal or the direct signal. The controller 204 may control an operation of the first switch 302 of the first communication unit 200 to be turned on based on the wide-area signal. The controller 204 may control an operation of the second switch 402 of the second communication unit 202 to be turned on based on the direct signal.

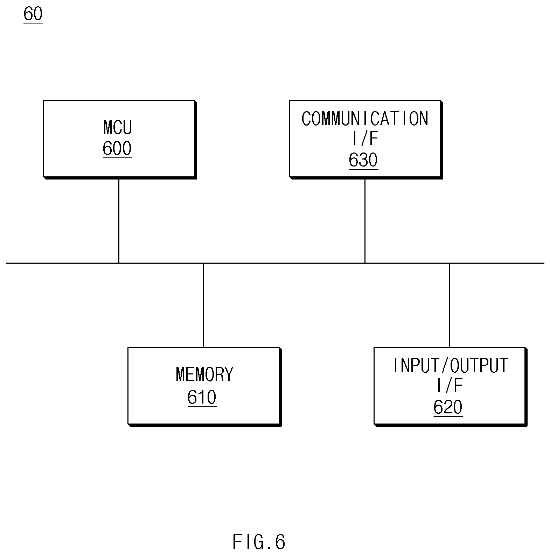

FIG. 6 is a block diagram showing a hardware configuration of a computing system for implementing an operating method of a battery management apparatus, according to an embodiment disclosed herein.

Referring to FIG. 6, a computing system 60 according to an embodiment disclosed herein may include a micro control unit (MCU) 600, a memory 610, an input/output I/F 620, and a communication I/F 630.

The MCU 600 may be a processor that executes various programs (e.g., a battery voltage analysis program, etc.) stored in the memory 610, processes various data through these programs, and perform the above-described functions of the battery management apparatus 20 shown in FIGS. 2 to 4.

The memory 610 may store various programs regarding operations of the battery management apparatus 20. Moreover, the memory 610 may store operation data of the battery management apparatus 20.

The memory 610 may be provided in plural, depending on a need. The memory 610 may be a volatile or nonvolatile memory. For the memory 610 as the volatile memory, random access memory (RAM), dynamic RAM (DRAM), static RAM (SRAM), etc., may be used. For the memory 610 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 610 are merely examples and are not limited thereto.

The input/output I/F 620 may provide an interface for transmitting and receiving data by connecting an input device (not shown) such as a keyboard, a mouse, a touch panel, etc., and an output device such as a display (not shown), etc., with the MCU 600.

The communication I/F 630, which is a component capable of transmitting and receiving various data to and from a server, may be various types of devices capable of supporting wired or wireless communication. For example, a program for resistance measurement and abnormality diagnosis or various data, etc., may be transmitted and received to and from a separately provided external server through the communication I/F 630.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

## Claims

1. A battery management apparatus comprising:
a first communication unit configured to broadcast a wide-area signal for communication with a plurality of slave battery management systems (BMSs) to the plurality of slave BMSs;
a second communication unit configured to transmit a direct signal for direction communication with a specific slave BMS among the plurality of slave BMSs to the specific slave BMS; and
a controller configured to control operations of the first communication unit and the second communication unit.

2. The battery management apparatus of claim 1, wherein the first communication unit further comprises a condensing mirror configured to concentrate light on a specific point by reflecting the wide-area signal.

3. The battery management apparatus of claim 1, wherein the first communication unit further comprises a first light-emitting diode configured to transmit the wide-area signal, and the second communication unit further comprises a second light-emitting diode configured to transmit the direct signal.

4. The battery management apparatus of claim 3, wherein the first communication unit further comprises a first switch configured to supply current to the first light-emitting diode, and the second communication unit further comprises a second switch configured to supply current to the second light-emitting diode, and the controller is further configured to control an operation of at least one of the first switch and the second switch.

5. The battery management apparatus of claim 1, wherein the second communication unit further comprises a receiver configured to receive diagnosis data regarding a battery generated by at least one of the plurality of slave BMSs based on the wide-area signal or the direct signal.

6. The battery management apparatus of claim 5, wherein the diagnosis data comprises at least one of voltage, current, and temperature of the battery.

7. The battery management apparatus of claim 1, wherein the wide-area signal comprises a block signal for blocking communication in a daisy chain manner among the plurality of slave BMSs.

8. An operating method of a battery management apparatus, the operating method comprising:
broadcasting a wide-area signal for communication with a plurality of slave battery management systems (BMSs) to the plurality of slave BMSs; and
reflecting the wide-area signal to simultaneously transmit the wide-area signal to a receiver of each of the plurality of slave BMSs.

9. The operating method of claim 8, wherein the wide-area signal comprises a block signal for blocking communication in a daisy chain manner among the plurality of slave BMSs.

10. The operating method of claim 8, further comprising receiving diagnosis data regarding a battery generated by at least one of the plurality of slave BMSs based on the wide-area signal.

11. The operating method of claim 10, wherein the diagnosis data comprises at least one of voltage, current, and temperature of the battery.
